# EUROPEAN PATENT APPLICATION

(11) **EP 4 693 383 A1**
(43) Date of publication of application: **11.02.2026**
(21) Application number: 25157979.3
(22) Date of filing: 14.02.2025
(51) Int. Cl.: H01L 21/67, H01L 21/68

(54) **WAFER ALIGNER**

(30) Priority: 05.08.2024 TW 113208362 U
(71) Applicant: Sanwa Engineering Corp., Qionglin Township, Hsinchu 307409 (TW)
(72) Inventor: CHIANG, Han-Yin, 307409 Qionglin Township, Hsinchu (TW); HSIAO, Ching-Yu, 307409 Qionglin Township, Hsinchu (TW); CHEN, Po-Yen, 307409 Qionglin Township, Hsinchu (TW)
(74) Representative: Schmidbauer, Andreas Konrad

(57) **Abstract**

A wafer aligner (100) that includes a body (110), a stage (130), a stand (120), an optical module (140) and a control module (CM) is provided. The stage (130) is movably disposed on the body (110). The stand (120) is vertically disposed on the body (110) and partially suspended above the body (110) to allow the stand (120) and the body (110) to form a detection space (IS). A wafer (200) is carried on the stage (130) and driven by the stage (130) to rotate relative to the body (110), and an edge of the wafer (200) passes by the detection space (IS). At least one surface of the detection space (IS) formed by the stand (120) and the body (110) is a light-absorbing surface. The optical module (140) includes a light source (142) and an image capture device (141).

## Description

### BACKGROUND

### Technical Field

The disclosure relates to a semiconductor device, and in particular to a wafer aligner.

### Description of Related Art

With the advancement of technology and improvement of people's living standards, semiconductor electronic products have been widely applied in various fields of society and life and are an indispensable part of modern life. Before a semiconductor wafer enters a process equipment, the wafer needs to be aligned to allow a preset notch on the wafer to face a specific position to facilitate subsequent processing of the wafer after alignment.

Specifically, an existing wafer alignment method is to place a wafer on a tray, and a controller may control the rotation of the tray, and detect a notch of the wafer through a sensor to perform fast alignment and eccentricity correction to the wafer. Generally speaking, during the detection process, a light source needs to be illuminated to an edge of the wafer, and then the sensor is allowed to sense images of the edge to determine whether the notch exists or not. However, since the sensor is configured to sense images of the edge of the wafer, the sensor may be inevitably affected by the external ambient light source, and misjudgments of sensing results may be possible.

### SUMMARY

The disclosure provides a wafer aligner to efficiently complete wafer alignment and facilitate the performance of subsequent wafer processing technology.

The wafer aligner of the disclosure includes a body, a stage, a stand, an optical module, and a control module. The stage is movably disposed on the body. The stand is vertically disposed on the body and partially suspended above the body to allow the stand and the body to form a detection space. The wafer is carried on the stage and driven by the stage to rotate relative to the body, and an edge of the wafer passes by the detection space. At least one surface of the detection space formed by the stand and the body is a light-absorbing surface. The optical module includes a light source and an image capture device. The light source is disposed in the body. The image capture device is disposed in the stand. The control module is electrically connected to the stage and the optical module. The control module drives the light source to project a light beam. The light beam sequentially passes through the body and the detection space and is projected into the stand and received by the image capture device to detect the edge of the wafer.

In an embodiment of the disclosure, the foregoing stand has a connection structure and a detection structure. The connection structure is connected between the detection structure and the body. The detection structure is suspended above the body. The image capture device is located in the detection structure. The at least one surface includes a surface of the connection structure facing the detection space.

In an embodiment of the disclosure, the foregoing detection structure has a detection surface that is exposed to the detection space and facing the body. The surface of the connection structure facing the detection space is adjacent between the detection surface and the body.

In an embodiment of the disclosure, the foregoing stand has a connection structure and a detection structure. The connection structure is connected between the detection structure and the body. The detection structure is suspended above the body. The image capture device is located in the detection structure. The at least one surface includes a partial top surface of the body adjacent the connection structure.

In an embodiment of the disclosure, the foregoing partial top surface is an orthographic projection surface of the detection structure corresponding to the body.

In an embodiment of the disclosure, the foregoing body has an opening that is located within a range of a partial top surface, and the light beam that is projected by the light source passes through the opening and enters the detection space.

In an embodiment of the disclosure, the foregoing detection structure has a detection surface that is exposed to the detection space and facing the partial top surface. The connection structure is adjacent between the partial top surface and the detection surface.

In an embodiment of the disclosure, the foregoing stand has a connection structure and a detection structure. The connection structure is connected between the detection structure and the body. The detection structure is suspended above the body. The image capture device is located in the detection structure. The at least one surface includes a surface of the connection structure exposed to the detection space and a partial top surface of the body.

In an embodiment of the disclosure, the foregoing detection structure has a detection surface that is exposed to the detection space and facing the partial top surface. The surface of the connection structure exposed to the detection space is adjacent between the partial top surface and the detection surface.

In an embodiment of the disclosure, the foregoing light-absorbing surface is a black matte surface that has been anodized.

In an embodiment of the disclosure, the foregoing stage includes a planar moving platform and a rotating platform that are respectively electrically connected to the control module. The rotating platform is disposed on the planar moving platform. The planar moving platform performs planar movement on the body. The rotating platform rotates by a normal line of the plane.

In an embodiment of the disclosure, the foregoing stage further includes an attachment unit that is electrically connected to the control module and structurally communicates with the rotating platform. The control module drives the attachment unit to attach and fix the wafer on the rotating platform.

Based on the above, the wafer aligner forms the detection space by the stand and the body. When the wafer is driven by the stage to rotate, the edge of the wafer is allowed to pass by the detection space in order to allow the optical module to perform detection to the wafer passing by the detection space for the control module to determine the location of a notch of the wafer and to rotate the wafer to a specific position to achieve the alignment effect and to facilitate subsequent wafer processing technology.

More importantly, at least one surface of the detection space formed by the body and the stand is a light-absorbing surface. Therefore, when the light generated by the light source of the optical module passes by the detection space, the light may not be interfered by light from the external environment to allow the image capture device of the optical module to smoothly capture images of the wafer at the edge thereof and improve detection accuracy.

### BRIEF DESCRIPTION OF THE DRAWINGS

FIG. 1 is a schematic view of a wafer aligner and a wafer according to an embodiment of the disclosure.
FIG. 2 is a schematic view of the wafer aligner in FIG. 1.
FIG. 3 is a side view of the wafer aligner in FIG. 1.

### DESCRIPTION OF THE EMBODIMENTS

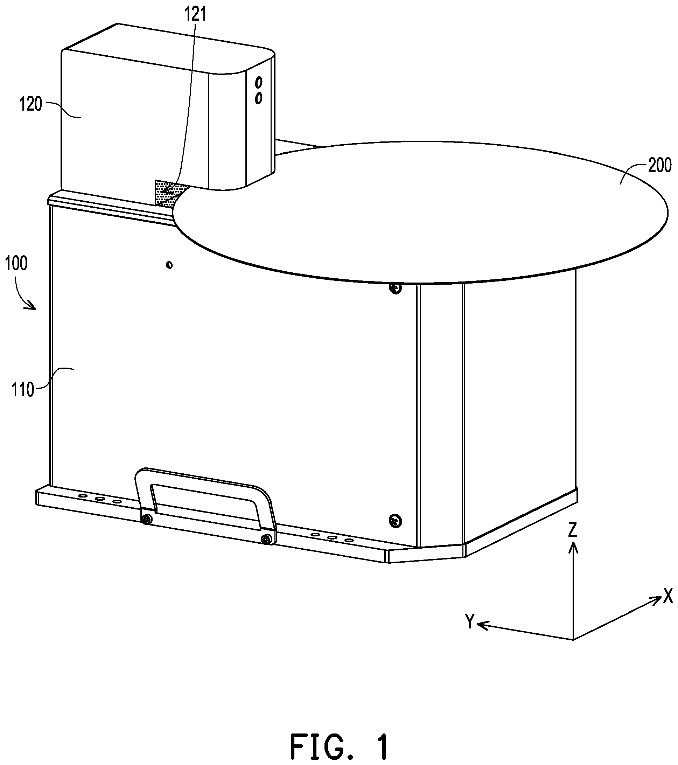

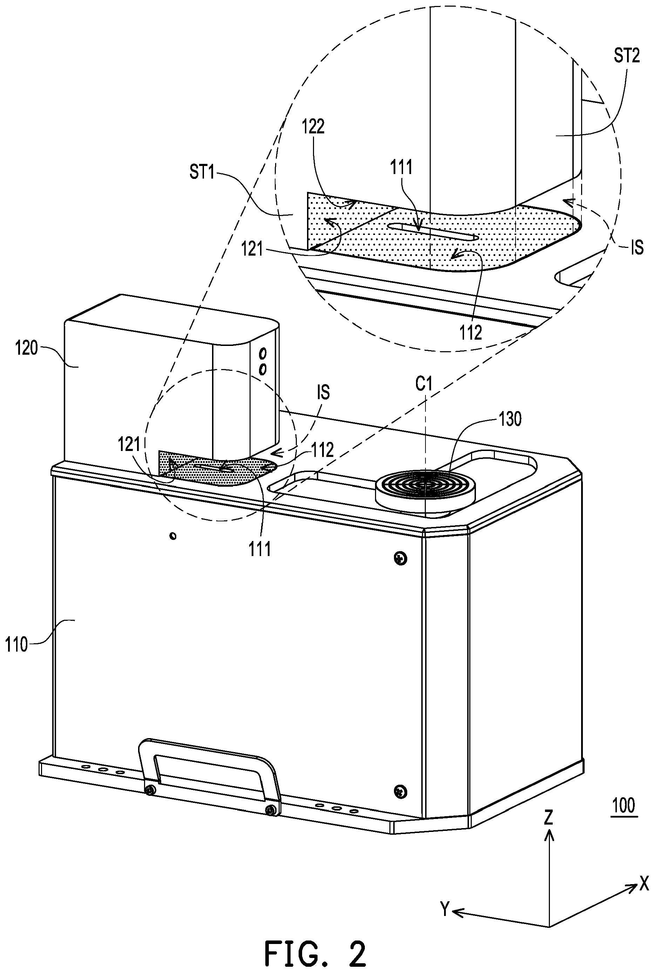

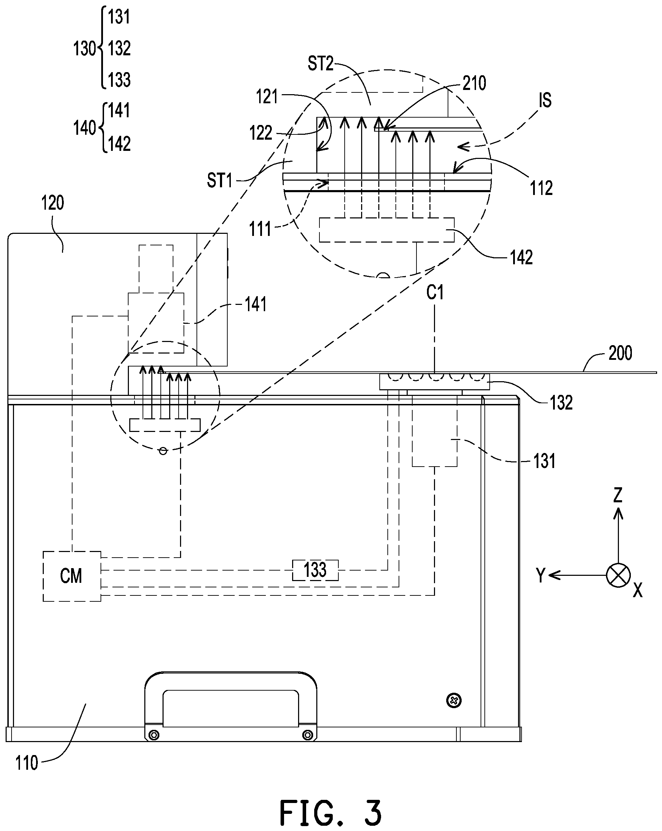

FIG. 1 is a schematic view of a wafer aligner and a wafer according to an embodiment of the disclosure. FIG. 2 is a schematic view of the wafer aligner in FIG. 1. FIG. 3 is a side view of the wafer aligner in FIG. 1. Cartesian coordinates XYZ are provided here to facilitate the description of components. Please refer to FIG. 1 to FIG. 3 at the same time. In the embodiment, a wafer aligner 100 includes a body 110, a stage 130, a stand 120, an optical module 140 and a control module CM. The stage 130 is movably disposed on the body 110. The stand 120 is vertically disposed on the body 110 and is partially suspended above the body 110 to allow the stand 120 and the body 110 to form a detection space IS. A wafer 200 is carried on the stage 130 and driven by the stage 130 to rotate relative to the body 110 and to allow an edge of the wafer 200 to pass by the detection space IS. At least one surface of the detection space IS formed by the stand 120 and the body 110 is a light-absorbing surface. The optical module 140 includes a light source 142 and an image capture device 141. The light source 142 is disposed in the body 110, and the image capture device 141 is disposed in the stand 120. The control module CM is electrically connected to the stage 130 and the optical module 140. The control module CM drives the light source 142 to project a light beam. The light beam sequentially passes through the body 110 and the detection space IS and is projected into the stand 120 and received by the image capture device 141 to perform detection to the edge of the wafer 200.

Specifically, as shown in FIG. 2 and FIG. 3, the stage 130 includes a planar moving platform 131 and a rotating platform 132 that are respectively electrically connected to the control module CM. The rotating platform 132 is disposed on the planar moving platform 131, and the planar moving platform 131 performs planar movement on the body 110 (moving along an X-Y plane), and the rotating platform 132 rotates by a normal line of the X-Y plane (that is, a Z axis). A rotating axis C1 followed by the rotating platform 132 is substantially parallel to the Z-axis. Furthermore, the stage 130 further includes an attachment unit 133, such as a vacuum pump, that is electrically connected to the control module CM and structurally communicates with the rotating platform 132. As shown in FIG. 3, multiple attachment openings are formed on a top surface of the rotating platform 132. Therefore, the control module CM may drive the attachment unit 133 to attach and fix the wafer 200 that is carried on the rotating platform 132.

On the other hand, as shown in FIG. 2 and FIG. 3, the stand 120 has a connection structure ST1 and a detection structure ST2. The connection structure ST1 is connected between the detection structure ST2 and the body 110. The detection structure ST2 is suspended above the body 110. The image capture device 141 is located in the detection structure ST2. Furthermore, the detection structure ST2 has a detection surface 122 that is exposed to the detection space IS and facing a partial top surface 112 of the body 110. A surface 121 of the connection structure ST1 facing the detection space IS is adjacent between to the detection surface 122 and the partial top surface 112 of the body 110. In particular, at least one surface of the foregoing detection space IS is a light-absorbing surface, that is, including the surface 121 of the connection structure ST1 facing the detection space IS and the partial top surface 112 of the body 110 adjacent to the connection structure ST1. The light-absorbing surface is, for example, a black matte surface that has been anodized, that is, allowing the light beam generated by the light source 142 to effectively avoid interference from external ambient light when passing through the detection space IS.

As shown in FIG. 2 and FIG. 3, the body 110 has an opening 111 that is located within a range of the partial top surface 112, and the light beam generated by the light source 142 may pass through the opening 111 and then enter the detection space IS, and pass by the edge of the wafer 200 as shown in FIG. 3. In this way, as the wafer 200 is driven by the stage 130 and rotates by the rotating axis C1, the edge of the wafer 200 may continuously pass by the detection space IS. The image capture device 141 may continuously obtain images of the wafer 200 at the edge thereof until a notch 210 of the wafer 200 is found (as shown in FIG. 3, a luminous flux of the light beam passing through the notch 210 position is obviously different from a luminous flux of the light beam passing through a non-notch position). After that, the control module CM may further drive the stage 130 to rotate and move the wafer 200 to a specific position to facilitate subsequent wafer processing technology.

Since the surface 121 and the partial top surface 112 shown in FIG. 2 and FIG. 3 are both light-absorbing surfaces, external ambient light may be effectively blocked from the light path shown in FIG. 3 to ensure that the light beam projected from the opening 111 may smoothly pass by the wafer 200 and then enter the detection structure ST2 and be received by the image capture device 141. In addition, as shown in FIG. 2, the partial top surface 112 of the body 110 is essentially an orthographic projection surface of the detection structure ST2 corresponding to the body 110 to smoothly surround the opening 111 that the light beam passes through.

In summary, in the foregoing embodiments of the disclosure, the wafer aligner forms the detection space with the stand and the body, so that when the wafer is driven by the stage to rotate, the edge thereof may pass by the detection space to allow the optical module to continuously detect the wafer that passes by the detection space for the control module to determine the location of the notch of the wafer and complete a required alignment. After that, the control module rotates and moves the wafer to a specific position through the stage to facilitate subsequent wafer processing technology.

More importantly, at least one surface of the detection space formed by the body and stand is a light-absorbing surface and includes the surface of the connection structure facing the detection space and the partial top surface of the body. The body further has the opening for the light beam to pass through, and the opening is substantially surrounded by the light-absorbing surface. In other words, there are substantially light-absorbing surfaces in the surrounding structure of the detection space to avoid external ambient light from being projected to the surrounding structure and then reflected or refracted through the detection space and affect the execution of the light beam generated by the light source. Therefore, the light generated by the light source of the optical module may not be interfered by the light of the external environment when passing by the detection space to allow the image capture device of the optical module to smoothly capture images of the wafer at the edge thereof and improve determination accuracy.

## Claims

1. A wafer aligner (100), comprising:
a body (110);
a stage (130), movably disposed on the body (110);
a stand (120), vertically disposed on the body (110) and partially suspended above the body (110) to allow the stand (120) and the body (110) to form a detection space (IS), a wafer (200) carried on the stage (130) and driven by the stage (130) to rotate relative to the body (110), and an edge of the wafer (200) passing by the detection space (IS), wherein at least one surface of the detection space (IS) formed by the stand (120) and the body (110) is a light-absorbing surface;
an optical module (140), comprising a light source (142) and an image capture device (141), the light source (142) disposed in the body (110), and the image capture device (141) disposed in the stand (120); and
a control module (CM), electrically connected the stage (130) and the optical module (140), wherein the control module (CM) drives the light source (142) to project a light beam, and the light beam sequentially passes through the body (110) and the detection space (IS) and is projected into the stand (120) and received by the image capture device (141) to detect the edge of the wafer (200).

2. The wafer aligner (100) according to claim 1, wherein the stand (120) has a connection structure (ST1) and a detection structure (ST2), the connection structure (ST1) is connected between the detection structure (ST2) and the body (110), the detection structure (ST2) is suspended above the body (110), the image capture device (141) is located in the detection structure (ST2), and the at least one surface comprises a surface (121) of the connection structure (ST1) facing the detection space (IS).

3. The wafer aligner (100) according to claim 2, wherein the detection structure (ST2) has a detection surface (122) that is exposed to the detection space (IS) and facing the body (110), and the surface (121) of the connection structure (ST1) facing the detection space (IS) is adjacent between the detection surface (122) and the body (110).

4. The wafer aligner (100) according to claim 1, wherein the stand (120) has a connection structure (ST1) and a detection structure (ST2), the connection structure (ST1) is connected between the detection structure (ST2) and the body (110), the detection structure (ST2) is suspended above the body (110), the image capture device (141) is located in the detection structure (ST2), and the at least one surface comprises a partial top surface (112) of the body (110) adjacent to the connection structure (ST1).

5. The wafer aligner (100) according to claim 4, wherein the partial top surface (112) is an orthographic projection surface of the detection structure (ST2) corresponding to the body (110).

6. The wafer aligner (100) according to claim 4, wherein the body (110) has an opening (111) that is located within a range of the partial top surface (112), and the light beam that is projected by the light source (142) passes through the opening (111) and enters the detection space (IS).

7. The wafer aligner (100) according to claim 6, wherein the detection structure (ST2) has a detection surface (122) that is exposed to the detection space (IS) and facing the partial top surface (112), and the connection structure (ST1) is adjacent between the partial top surface (112) and the detection surface (122).

8. The wafer aligner (100) according to claim 1, wherein the stand (120) has a connection structure (ST1) and a detection structure (ST2), the connection structure (ST1) is connected between the detection structure (ST2) and the body (110), the detection structure (ST2) is suspended above the body (110), the image capture device (141) is located in the detection structure (ST2), and the at least one surface comprises a surface (121) of the connection structure (ST1) exposed to the detection space (IS) and a partial top surface (112) of the body (110).

9. The wafer aligner (100) according to claim 8, wherein the detection structure (ST2) has a detection surface (122) that is exposed to the detection space (IS) and facing the partial top surface (112), and the surface (121) of the connection structure (ST1) exposed to the detection space (IS) is adjacent between the partial top surface (112) and the detection surface (122).

10. The wafer aligner (100) according to claim 1, wherein the light-absorbing surface is a black matte surface that has been anodized.

11. The wafer aligner (100) according to claim 1, wherein the stage (130) comprises a planar moving platform (131) and a rotating platform (132) that are respectively electrically connected to the control module (CM), the rotating platform (132) is disposed on the planar moving platform (131), the planar moving platform (131) performs planar movement on the body (110), and the rotating platform (132) rotates by a normal line of the plane.

12. The wafer aligner (100) according to claim 11, wherein the stage (130) further comprises an attachment unit (133) that is electrically connected to the control module (CM) and structurally communicates with the rotating platform (132), and the control module (CM) drives the attachment unit (133) to attach and fix the wafer (200) on the rotating platform (132).
